# EUROPEAN PATENT APPLICATION

(11) **EP 4 738 601 A1**
(43) Date of publication of application: **06.05.2026**
(21) Application number: 25213218.8
(22) Date of filing: 04.11.2025
(51) Int. Cl.: H01Q 1/12, H01Q 1/22, H01Q 21/06, H01Q 21/10, H01Q 21/20, H01Q 21/28

(54) **DISPLAY DEVICE**

(30) Priority: 05.11.2024 KR 20240155292
(71) Applicant: LG Electronics Inc., Yeongdeungpo-gu Seoul 07336 (KR)
(72) Inventor: SONG, Moonsoo, Seoul (KR)
(74) Representative: Vossius & Partner Patentanwälte Rechtsanwälte mbB

(57) **Abstract**

A display device including a display panel having a plane for displaying an image; a frame which is positioned at a rear of the display panel, and to which the display panel is coupled; and a communication module which is positioned at one side of the frame, and protrudes outward from the one side of the frame, in which the communication module includes: a housing providing an internal space; and an antenna unit which is positioned in the internal space of the housing, has a bottom surface intersecting with the plane of the display panel, and has a side surface that forms an edge of the bottom surface and faces a front of the display panel.

## Description

### TECHNICAL FIELD

This disclosure relates to a display device.

### BACKGROUND

As the information society develops, the demand for display devices is also increasing in various forms. In response to this, various display devices such as Liquid Crystal Display Device (LCD), Organic Light Emitting Diodes (OLED), and Micro LED have been researched and used in recent years.

Among these, the LCD panel has a TFT substrate and a color substrate that are opposite to each other with a liquid crystal layer interposed therebetween, and may display images by using light provided from a backlight unit. In addition, an OLED panel may display images by depositing an organic layer that can emit light naturally on a substrate on which a transparent electrode is formed. In particular, a display device equipped with an OLED panel has the advantage of being able to be implemented in an ultra-thin form because it does not require a backlight unit.

A control box can be used separately from the display device, while being adjacent to a user. The control box can provide various information to the display device. For example, the control box may be an AV box. The control box can exchange information with a display head equipped with a display panel that displays an image, by wire/wireless.

Recently, much research has been conducted on the connectivity of such a display device.

### SUMMARY

The disclosure has been made in view of the above problems, and may provide a display device having a wireless communication module.

The disclosure may further provide a display device capable of improving the reception rate of an antenna of a communication module.

The disclosure may further provide a display device capable of improving the radiation performance of an antenna of a communication module.

The disclosure may further provide a radome and an air room structure inside the radome for improving the radiation performance of an antenna that may be interfered with by electronic components surrounding an antenna of a communication module.

The disclosure may further provide a structure capable of effectively dissipating heat from a communication module.

The disclosure may further provide a display device capable of improving the assembly durability of an antenna.

In accordance with an aspect of the present disclosure, a display device includes: a display panel having a plane for displaying an image; a frame which is positioned at a rear of the display panel, and to which the display panel is coupled; and a communication module which is positioned at one side of the frame, and protrudes outward from the one side of the frame, in which the communication module includes: a housing providing an internal space; and an antenna unit which is positioned in the internal space of the housing, has a bottom surface intersecting with the plane of the display panel, and has a side surface that forms an edge of the bottom surface and faces a front of the display panel, in which the antenna unit includes: a plurality of first antennas arranged on the bottom surface of the antenna unit; and a plurality of second antennas arranged on the side surface of the antenna unit, in which the housing includes: a lower rib forming a first air room by supporting the bottom surface of the antenna unit in the housing facing the bottom surface of the antenna unit; and a spacer which supports the side surface of the antenna unit and forms a second air room between the housing and the side surface of the antenna unit.

### BRIEF DESCRIPTION OF THE DRAWINGS

The above and other objects, features and advantages of the present invention will be more apparent from the following detailed description in conjunction with the accompanying drawings, in which:

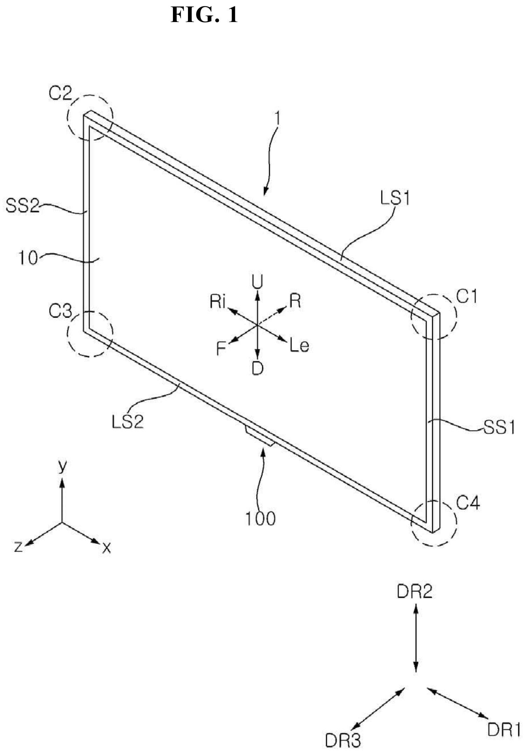

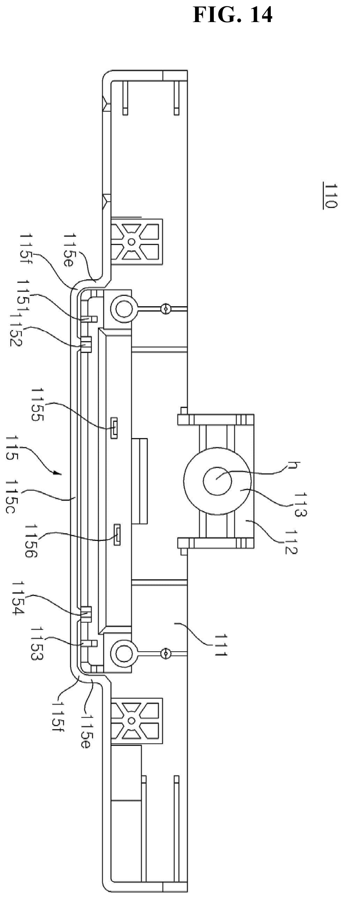

FIGS. 1 to 18 are drawings illustrating examples of a display device according to embodiments of the present disclosure.

### DETAILED DESCRIPTION

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In general, suffixes such as "module" and "unit" may be used to refer to elements or components. Use of such suffixes herein is merely intended to facilitate description of the specification, and the suffixes do not have any special meaning or function.

In the present disclosure, that which is well known to one of ordinary skill in the relevant art has generally been omitted for the sake of brevity. The accompanying drawings are used to assist in easy understanding of various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are only used to distinguish one element from another.

It will be understood that when an element is referred to as being "connected with" another element, there may be intervening elements present. In contrast, it will be understood that when an element is referred to as being "directly connected with" another element, there are no intervening elements present.

A singular representation may include a plural representation unless context clearly indicates otherwise.

In the present application, it should be understood that the terms "comprises, includes," "has," etc. specify the presence of features, numbers, steps, operations, elements, components, or combinations thereof described in the specification, but do not preclude the presence or addition of one or more other features, numbers, steps, operations, elements, components, or combinations thereof.

The direction indications of up U, down D, left Le, right Ri, front F, and rear R shown in the drawings are only for the convenience of explanation, and the technical concepts disclosed in this specification are not limited thereby.

Referring to FIG. 1, a display device 1 may include a display panel 10. The display panel 10 may display an image on a front surface.

The display 1 may include a first long side LS1, a second long side LS2 opposite to the first long side LS1, a first short side SS1 adjacent to the first long side LS1 and the second long side LS2, and a second short side SS2 opposite to the first short side SS1. Meanwhile, for convenience of explanation, it is illustrated that the lengths of the first and second long sides LS1 and LS2 are longer than the lengths of the first and second short sides SS1 and SS2, but it may be possible that the lengths of the first and second long sides LS1 and LS2 are approximately the same as the lengths of the first and second short sides SS1 and SS2.

The direction parallel to the long sides LS1, LS2 of the display device 1 may be referred to as a left-right direction or a first direction DR1. The direction parallel to the short sides SS1, SS2 of the display device 1 may be referred to as an up-down direction or a second direction DR2. The direction perpendicular to the long sides LS1, LS2 and the short sides SS1, SS2 of the display device 1 may be referred to as a front-rear direction or a third direction DR3.

The direction in which the display panel 10 displays an image may be referred to as a forward direction (F, z), and the opposite direction may be referred to as a rearward direction (R, -z). The first long side LS1 side may be referred to as an upper side (U, y). The second long side LS2 side may be referred to as a lower side (D, -y). The first short side SS1 side may be referred to as a left side (Le, x). The second short side SS2 side may be referred to as a right side (Ri, -x).

The first long side LS1, the second long side LS2, the first short side SS1, and the second short side SS2 may be referred to as an edge of the display device 1. In addition, a point where the first long side LS1, the second long side LS2, the first short side SS1, and the second short side SS2 meet each other may be referred to as a corner.

For example, a point where the first short side SS1 and the first long side LS1 meet may be referred to as a first corner C1. A point where the first long side LS1 and the second short side SS2 meet may be referred to as a second corner C2. A point where the second short side SS2 and the second long side LS2 meet may be referred to as a third corner C3. A point where the second long side LS2 and the first short side SS1 meet may be referred to as a fourth corner C4.

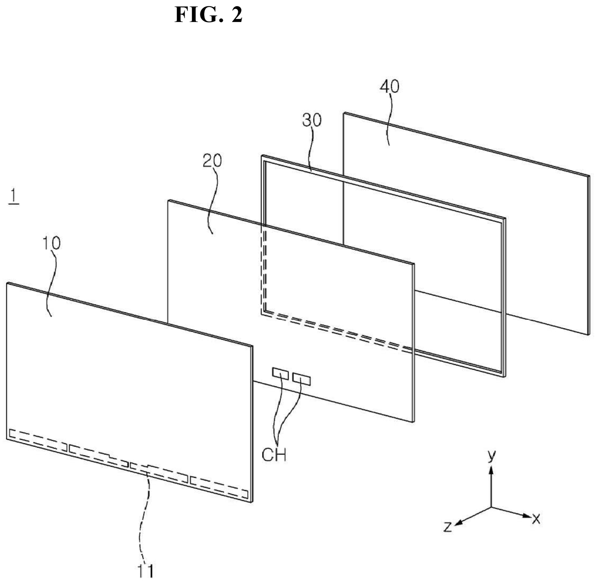

Referring to FIGS. 1 and 2, the display device 1 may include a display panel 10, a frame 20, a side frame 30, and a back cover 40.

The display panel 10 may form the front surface of the display device 1 and may display an image in a forward direction. For example, the display panel 10 may be an Organic Light Emitting Diode (OLED) panel. However, the display panel applicable to the present disclosure is not limited to an OLED panel. The display panel 10 may divide an image into a plurality of pixels and output an image by adjusting the color, brightness, and saturation for each pixel. The display panel 10 may be divided into an active area where an image is displayed and a de-active area where an image is not displayed. The display panel 10 may generate light corresponding to the color of red, green, or blue according to a control signal.

The frame 20 may be positioned at the rear of the display panel 10, and the display panel 10 may be coupled to the frame 20. For example, the frame 20 may include a metal material. A cable hole CH may be formed by penetrating the frame 20. Meanwhile, the frame 20 may be referred to as a main frame 20 or a module cover 20 or a rear frame 20.

The side frame 30 may extend along the circumference of the frame 20. The frame 20 may be coupled to the side frame 30 at the front or rear of the side frame 30. The side frame 30 may cover the side surface of the display panel 10 and the frame 20. Meanwhile, the side frame 30 may be referred to as a guide panel.

The back cover 40 may be positioned at the rear of the frame 20 and may be coupled to the frame 20. For example, the back cover 40 may be an injection product of a resin material. For another example, the back cover 40 may include a metal material.

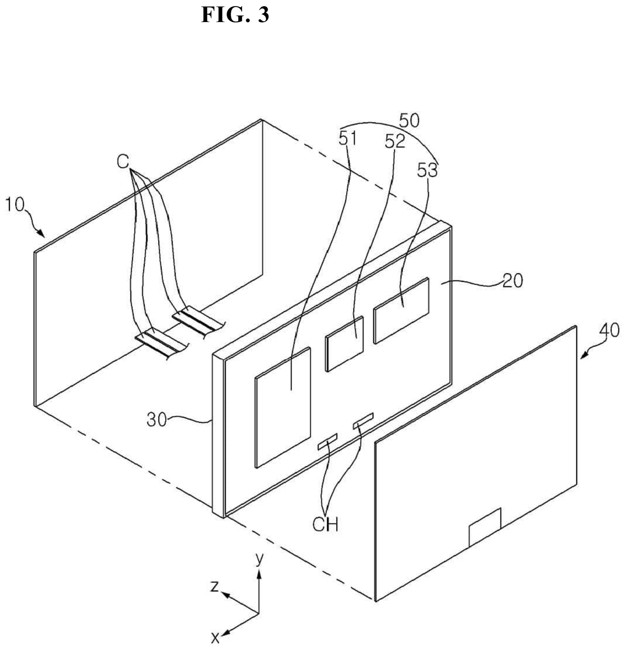

Referring to FIG. 3, boards 50 may be mounted on the frame 20 at the rear of the frame 20. A plurality of electronic components may be mounted on the boards 50. The board 50 may be a Printed Circuit Board (PCB), and may be electrically connected to electronic components of the display device.

For example, the boards 50 may include a power supply board 51 that provides power to each component of the display device, a timing controller board 52 that provides a video signal to the display panel 10, and a main board 53 that provides a video signal to the display panel 10 and/or the timing controller board 52, and controls the display device.

Meanwhile, a Source PCB 11 (S-PCB, see FIG. 2) may be adjacent to the lower side of the display panel 10, and may be coupled to the rear surface of the display panel 10. The cable C may pass through a cable hole CH formed at the lower side of the frame 20, and may connect the S-PCB 11 and the timing controller board 52. Accordingly, the cable C may transmit digital video data and a timing control signal from the timing controller board 52 to the S-PCB 11. For example, the cable C may be a Flexible Flat Cable (FFC).

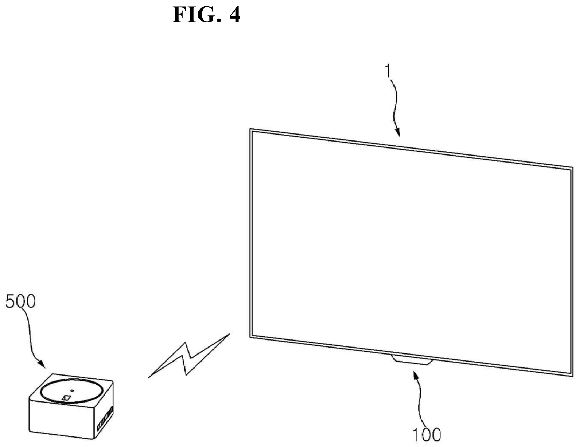

Referring to FIG. 4, a control box 500 may be separated from the display device 1. The control box 500 may be referred to as a set-top box. The control box 500 may wirelessly exchange information with the display device 1. A communication module (not shown) of the control box 500 may wirelessly communicate with a communication module 100 of the display device 1. At least a portion of the communication module 100 may protrude outward from the edge of the display device 1. Accordingly, the communication module 100 may wirelessly communicate smoothly with the communication module of the control box 500.

The stability of wireless communication between the control box 500 and the display device 1 may vary depending on the relative positions of the control box 500 and the display device 1. The display device 1 may be positioned at a constant location in order to maintain a constant distance from a user. The control box 500 needs to have a high degree of freedom in the location for user convenience.

Meanwhile, the control box 500 may be a component of the display device 1. In this case, the display device 1 including the display panel 10 may be referred to as a display head 1. That is, the display device may include the display head 1 and the control box 500.

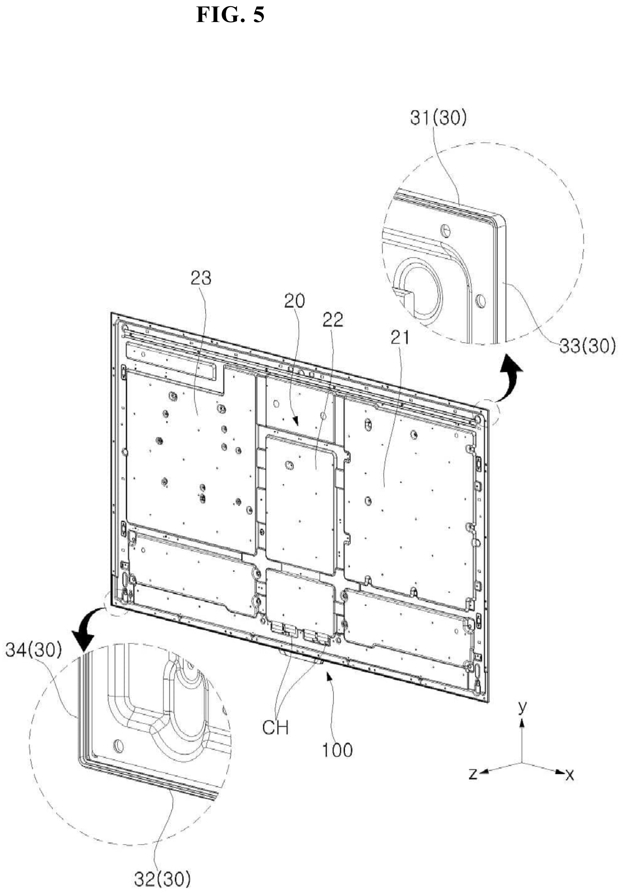

Referring to FIG. 5, the side frame 30 may include a first part 31, a second part 32, a third part 33, and a fourth part 34. The first part 31 may extend along the upper side of the frame 20, and form the first long side LS1 (see FIG. 1). The third part 33 may be bent downward from the right distal end of the first part 31, may be extended along the right side of the frame 20, and may form the second short side SS2 (see FIG. 1). The second part 32 may be bent from the lower distal end of the third part 33, may be extended along the lower side of the frame 20, and may form the second long side LS2 (see FIG. 1). The fourth part 34 may be bent upward from the distal end of the second part 32, may be extended along the left side of the frame 20, and may form the first short side SS1 (see FIG. 1).

A first forming portion 21, a second forming portion 22, and a third forming portion 23 may be formed by being pressed from the front to the rear of the frame 20. The first forming portion 21 may be positioned close to the right side of the frame 20, the third forming portion 23 may be positioned close to the left side of the frame 20, and the second forming portion 22 may be positioned between the first forming portion 21 and the third forming portion 23. For example, the power supply board 51 (see FIG. 3) may be mounted on the rear surface of the third forming portion 23. For example, the timing controller board 52 (see FIG. 3) may be mounted on the rear surface of the second forming portion 22. For example, the main board 53 (see FIG. 3) may be mounted on the rear surface of the first forming portion 21.

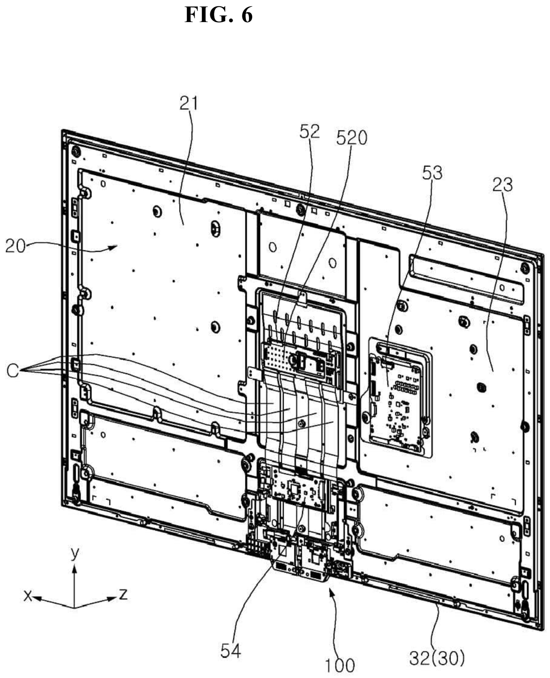

Referring to FIG. 6, a shield plate 520 may be mounted on the rear surface of the timing controller board 52. A first board 54 may be spaced downwardly from the timing controller board 52, and may be mounted on the rear surface of the frame 20. A second board 53 may be spaced rightwardly from the timing controller board 52, and may be mounted on the rear surface of the frame 20. A shield plate (not shown) may also be mounted on the rear surface of each of the first board 54 and the second board 53. The communication module 100 may receive compressed sound and/or video data from the communication module of the control box 500 (see FIG. 4). The first board 54 may decompress the sound and/or video data received from the communication module 100, convert it, and provide it to the second board 53. The second board 53 may provide data received from the first board 54 to the display panel 10 (see FIG. 3) through the timing controller board 52. For example, the first board 54 may be a waveform audio format board (WAV) or a WAV22 board, and the second board 53 may be an amplifier (AMP) board. For example, the third board 53 may be a main board 53. The communication module 100 may be referred to as a communication unit 100 or a communication box 100.

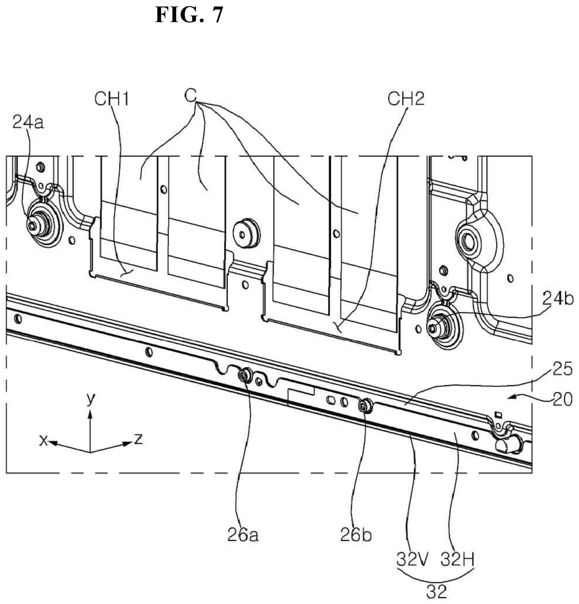

Referring to FIG. 7, a first cable hole CH1 and a second cable hole CH2 may be formed by penetrating the frame 20 in the front-rear direction, and may be adjacent to the second part 32. The first cable hole CH1 may be adjacent to the second cable hole CH2, but may be separated from it. For example, four cables C may form two pairs, one pair may pass through the first cable hole CH1, and the remaining pair may pass through the second cable hole CH2.

The second part 32 may include a vertical portion 32V and a horizontal portion 32H. The vertical portion 32V may extend along the lower side of the frame 20, and form a lower side of the second part 32. The vertical portion 32V may have a width in a direction intersecting with the frame 20. In other words, the length of the vertical portion 32V may be defined in the left-right direction, the width of the vertical portion 32V may be defined in the front-rear direction, and the thickness of the vertical portion 32V may be defined in the up-down direction.

The horizontal portion 32H may protrude from the upper side of the frame 20 toward the rear of the frame 20. The horizontal portion 32H may be arranged parallel to the frame 20 at the rear of the frame 20. In other words, the length of the horizontal portion 32H may be defined in the left-right direction, the width of the horizontal portion 32H may be defined in the up-down direction, and the thickness of the horizontal portion 32H may be defined in the front-rear direction.

Meanwhile, a pressing portion 25 may be formed by being pressed in a forward direction from the rear surface of the frame 20, and may form the lower side of the frame 20. The front surface of the pressing portion 25 may be in contact with the rear surface of the horizontal portion 32H. The horizontal portion 32H may be coupled or fixed to the pressing portion 25.

A lower fixing portion 26a, 26b may protrude from the pressing portion 25 toward the horizontal portion 32H, and may penetrate the horizontal portion 32H. A first lower fixing portion 26a may be spaced to the left from a second lower fixing portion 26b. An upper fixing portion 24a, 24b may protrude rearwardly from the frame 20. A first upper fixing portion 24a may be adjacent to the first cable hole CH1, and a second upper fixing portion 24b may be adjacent to the second cable hole CH2.

For example, the lower fixing portion 26a, 26b and the upper fixing portion 24a, 24b may be a pemnut.

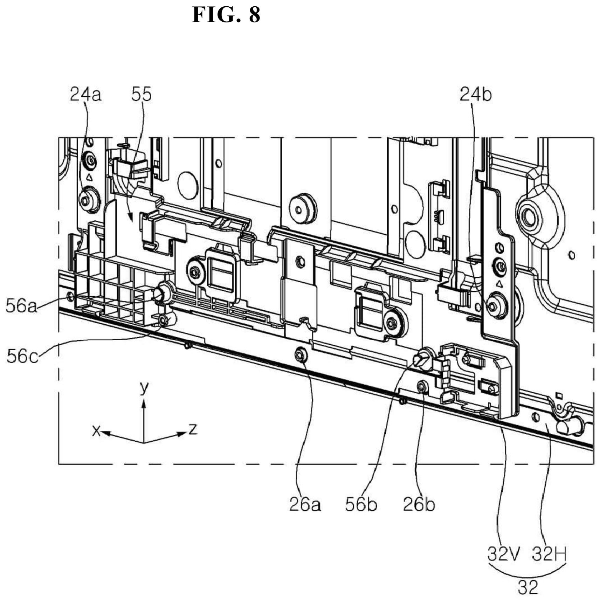

Referring to FIG. 8, a base 55 may be detachably coupled to the frame 20 and the second part 32 at the rear of the frame 20. The base 55 may be referred to as a mount base 55. The base 55 may be positioned on the upper side of the vertical portion 32V. A portion of the base 55 may cover at least a portion of the rear of the cable hole CH1, CH2 (see FIG. 7). A portion of the base 55 may cover a portion of the rear surface of the horizontal portion 32H. The lower fixing portion 26a, 26b and the upper fixing portion 24a, 24b may penetrate the base 55.

A boss 56a, 56b and a third lower fixing portion 56c may protrude rearwardly from the base 55. The third lower fixing portion 56c may be adjacent to the vertical portion 32V, and may face the horizontal portion 32H with respect to the base 55. The third lower fixing portion 56c may face the second lower fixing portion 26b with respect to the first lower fixing portion 26a. A first boss 56a may be adjacent to the third lower fixing portion 56c but may be spaced upward therefrom. A second boss 56b may be adjacent to the second lower fixing portion 26b but may be spaced upward therefrom. For example, the third lower fixing portion 56c may be a pemnut. Meanwhile, the boss 56a, 56b may be referred to as a fixing pin.

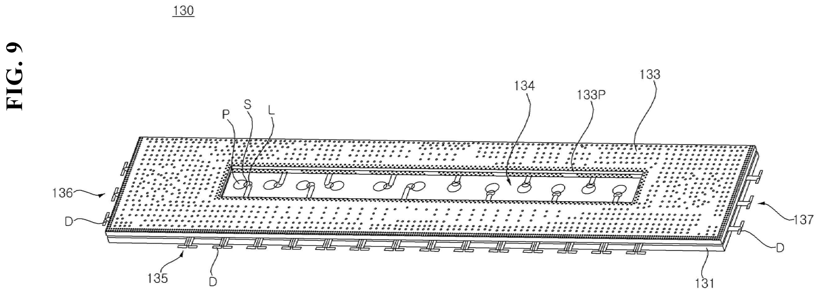

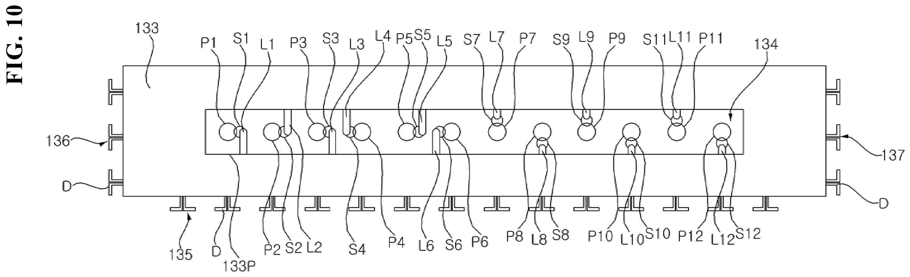

Referring to FIGS. 9 and 10, an antenna module 130 may include a substrate 131, a cover frame 133, a first antenna unit 134, a second antenna unit 135, a third antenna unit 136, and a fourth antenna unit 137. The cover frame 133 may be referred to as a cover layer 133. For example, the frequency band of the antenna module 130 may be 57 to 66 GHz.

The substrate 131 may be a rectangular PCB. The substrate 131 may have a front surface and a rear surface, and the front surface may face the rear surface. The length of the long side of the substrate 131 may be 4 to 6 times longer than the length of the short side of the substrate. For example, the length of the antenna module 130 may be 46 millimeters, and the width may be 9.5 millimeters.

The cover frame 133 may cover a portion of the front surface of the substrate 131. The cover frame 133 may correspond to the shape of the substrate 131 and may have an opening 133P in the center. The front surface of the substrate 131 may be referred to as the bottom surface of the substrate 131.

The first antenna unit 134 may be formed on the front surface of the substrate 131, and may be exposed to the outside through the opening 133P of the cover frame 133. The second antenna unit 135 may be positioned on the first long side of the substrate 131. The first long side of the substrate 131 may be referred to as a first side surface of the substrate 131 or one long side of the substrate 131. The second long side positioned opposite to the first long side of the substrate 131 may be referred to as a second side surface of the substrate 131 or the other long side of the substrate. The third antenna unit 136 may be positioned on one short side of the substrate 131, and the fourth antenna unit 137 may be positioned on the other short side of the substrate 131. The third antenna unit 136 may be positioned opposite to the fourth antenna unit 137 with respect to the first antenna unit 134.

The first antenna unit 134 may include a plurality of patches P and a plurality of feeding portions S. The patch P may be a circular electrode. The patches P may be arranged sequentially along the length direction of the substrate 131 while maintaining a constant interval from each other. For example, there may be 12 patches P1 to P12. The feeding portion S may be formed on the front surface of the substrate 131 while being adjacent to the patch P. The feeding portion S may be electrically connected to the patch P. For example, there may be 12 feeding portions S1 to S12. One feeding portion S may be connected to one patch P. The antenna module 130 may include a plurality of layers, and the patch P and the feeding portion S may be formed in different layers and may be electrically connected to each other.

A first feeding portion S1 may be adjacent to a first patch P1 at between the first patch P1 and a second patch P2. A portion of the first feeding portion S1 may overlap with a p portion of the first patch P1. The first feeding portion S1 may be electrically connected to the first patch P1. A first line L1 may be electrically connected to the first feeding portion S1. The first line L1 may extend from the first long side of the substrate 131 in a direction toward the first feeding portion S1 and may be connected to the first feeding portion S1.

A second feeding portion S2 may be adjacent to the second patch P2 at between the second patch P2 and a third patch P3. A portion of the second feeding portion S2 may overlap with a portion of the second patch P2. The second feeding portion S2 may be electrically connected to the second patch P2. A second line L2 may be electrically connected to the second feeding portion S2. The second line L2 may extend from the second long side opposite to the first long side of the substrate 131 in a direction toward the second feeding portion S2 and may be connected to the second feeding portion S2.

A third feeding portion S3 may be adjacent to the third patch P3 at between the third patch P3 and a fourth patch P4. A portion of the third feeding portion S3 may overlap with a portion of the third patch P3. The third feeding portion S3 may be electrically connected to the third patch P3. A third line L3 may be electrically connected to the third feeding portion S3. The third line L3 may extend from the first long side of the substrate 131 toward the third feeding portion S3 and be connected to the third feeding portion S3.

A fourth feeding portion S4 may be adjacent to the fourth patch P4 at between the fourth patch P4 and the third patch P3. A portion of the fourth feeding portion S4 may overlap with a portion of the fourth patch P4. The fourth feeding portion S4 may be electrically connected to the fourth patch P4. A fourth line L4 may be electrically connected to the fourth feeding portion S4. The fourth line L4 may extend from the second long side of the substrate 131 in a direction toward the fourth feeding portion S4 and may be connected to the fourth feeding portion S4.

A fifth feeding portion S5 may be adjacent to a fifth patch P5 at between the fifth patch P5 and a sixth patch P6. A portion of the fifth feeding portion S5 may overlap with a portion of the fifth patch P5. The fifth feeding portion S5 may be electrically connected to the fifth patch P5. A fifth line L5 may be electrically connected to the fifth feeding portion S5. The fifth line L5 may extend from the second long side of the substrate 131 in a direction toward the fifth feeding portion S5 and may be connected to the fifth feeding portion S5.

A sixth feeding portion S6 may be adjacent to the sixth patch P6 at between the fifth patch P5 and the sixth patch P6. A portion of the sixth feeding portion S6 may overlap with a portion of the sixth patch P6. The sixth feeding portion S6 may be electrically connected to the sixth patch P6. A sixth line L6 may be electrically connected to the sixth feeding portion S6. The sixth line L6 may extend from the first long side of the substrate 131 toward the sixth feeding portion S6 and may be connected to the sixth feeding portion S6.

The area where the first patch P1 to the sixth patch P6 are arranged may be defined as a first area. For example, the patches P1 to P6 arranged in the first area of the antenna module 130 may detect horizontal polarization.

A seventh feeding portion S7 may be adjacent to a seventh patch P7 at between the seventh patch P7 and the second long side of the substrate 131. A portion of the seventh feeding portion S7 may overlap with a portion of the seventh patch P7. The seventh feeding portion S7 may be electrically connected to the seventh patch P7. A seventh line L7 may be electrically connected to the seventh feeding portion S7. The seventh line L7 may extend from the second long side of the substrate 131 toward the seventh feeding portion S7 and may be connected to the seventh feeding portion S7.

An eighth feeding portion S8 may be adjacent to an eighth patch P8 at between the eighth patch P8 and the first long side of the substrate 131. A portion of the eighth feeding portion S8 may overlap with a portion of the eighth patch P8. The eighth feeding portion S8 may be electrically connected to the eighth patch P8. An eighth line L8 may be electrically connected to the eighth feeding portion S8. The eighth line L8 may extend from the first long side of the substrate 131 toward the eighth feeding portion S8 and be connected to the eighth feeding portion S8.

A ninth feeding portion S9 may be adjacent to a ninth patch P9 at between the ninth patch P9 and the second long side of the substrate 131. A portion of the ninth feeding portion S9 may overlap with a portion of the ninth patch P9. The ninth feeding portion S9 may be electrically connected to the ninth patch P9. A ninth line L9 may be electrically connected to the ninth feeding portion S9. The ninth line L9 may extend from the second long side of the substrate 131 toward the ninth feeding portion S9 and may be connected to the ninth feeding portion S9.

A tenth feeding portion S10 may be adjacent to a tenth patch P10 at between the tenth patch P10 and the first long side of the substrate 131. A portion of the tenth feeding portion S10 may overlap with a portion of the tenth patch P10. The tenth feeding portion S10 may be electrically connected to the tenth patch P10. A tenth line L10 may be electrically connected to the tenth feeding portion S10. The tenth line L10 may extend from the first long side of the substrate 131 toward the tenth feeding portion S10 and may be connected to the tenth feeding portion S10.

An eleventh feeding portion S11 may be adjacent to an eleventh patch P11 at between the eleventh patch P11 and the second long side of the substrate 131. A portion of the eleventh feeding portion S11 may overlap with a portion of the eleventh patch P11. The eleventh feeding portion S11 may be electrically connected to the eleventh patch P11. An eleventh line L11 may be electrically connected to the eleventh feeding portion S11. The eleventh line L11 may extend in a direction from the second long side of the substrate 131 toward the eleventh feeding portion S11 and may be connected to the eleventh feeding portion S11.

The twelfth feeding portion S12 may be adjacent to a twelfth patch P12 at between the twelfth patch P12 and the first long side of the substrate 131. A portion of the twelfth feeding portion S12 may overlap with a portion of the twelfth patch P12. The twelfth feeding portion S12 may be electrically connected to the twelfth patch P12. A twelfth line L12 may be electrically connected to the twelfth feeding portion S12. The twelfth line L12 may extend from the first long side of the substrate 131 toward the twelfth feeding portion S12 and may be connected to the twelfth feeding portion S12.

The area where the seventh patch P7 to the twelfth patch P12 are arranged may be defined as a second area. For example, the patches P7 to P12 arranged in the second area of the antenna module 130 may detect vertical polarization.

The second antenna unit 135 may be formed along the long side of the substrate 131. The second antenna unit 135 may include a plurality of dipoles D. The plurality of dipoles D may be formed sequentially along the long side of the substrate 131. For example, the plurality of dipoles D may be fourteen dipoles. For example, the second antenna unit 135 may detect horizontal polarization.

The third antenna unit 136 may be formed along one short side of the substrate 131. The third antenna unit 136 may include a plurality of dipoles D. The plurality of dipoles D may be formed sequentially along one short side of the substrate 131. For example, the plurality of dipoles D may be three dipoles. For example, the third antenna unit 136 may detect horizontal polarization.

The fourth antenna unit 137 may be formed along the other short side of the substrate 131. The fourth antenna unit 137 may include a plurality of dipoles D. The plurality of dipoles D may be formed sequentially along one short side of the substrate 131. For example, the plurality of dipoles D may be three dipoles. For example, the fourth antenna unit 137 may detect horizontal polarization.

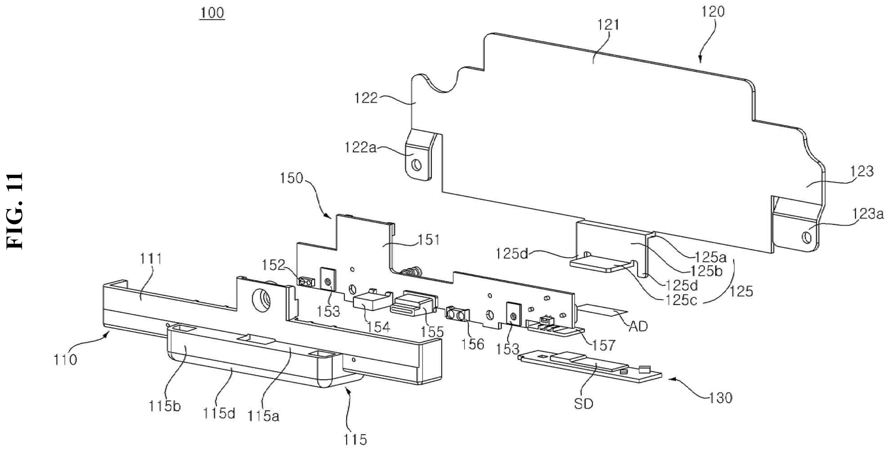

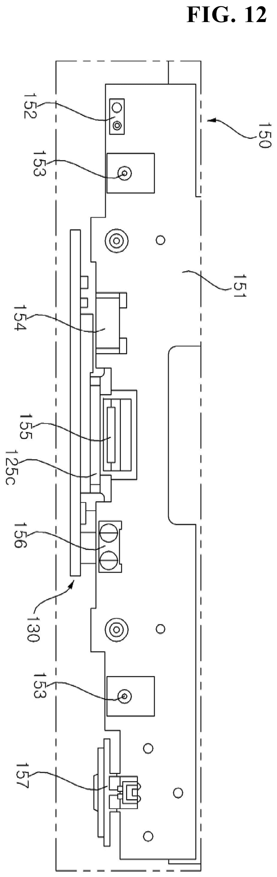

Referring to FIGS. 11 and 12, the communication module 100 may include a front cover 110, an inner plate 120, and an antenna module 130. The antenna module 130 may be referred to as an antenna 130 or an antenna unit 130. For example, the antenna module 130 may be an antenna in package (AIP).

The inner plate 120 may be referred to as a heat sink 120. The inner plate 120 may include metal. For example, the inner plate 120 may include aluminum. The inner plate 120 may include a center plate 121, a first side plate 122, and a second side plate 123. The first side plate 122 may be positioned opposite to the second side plate 123 with respect to the center plate 121. The inner plate 120 may face the rear surface of the frame 20 (see FIG. 8) or may be coupled to the frame 20 (see FIG. 8). The inner plate 120 may be fixed to the boss 56a, 56b, the upper fixing portion 24a, 24b and/or the lower fixing portion 26a, 26b described with reference to FIG. 8.

The inner plate 120 may include a side tab 122a, 123a. A first side tab 122a may extend from the first side plate 122. A second side tab 123a may extend from the second side plate 123. The side tab 122a, 123a may be coupled to the rear of the frame 20 (see FIG. 7). For example, the side tab 122a, 123a may be fixed to the boss 56a, 56b, the upper fixing portion 24a, 24b and/or the lower fixing portion 26a, 26b described with reference to FIG. 8.

The inner plate 120 may include a connecting plate 125. The connecting plate 125 may be positioned on the lower side of the center plate 121. The connecting plate 125 may include a first part 125a, a second part 125b, and a third part 125c. The first part 125a may extend to be curved in a forward direction from the lower end of the center plate 121. For example, the first part 125a may form a wall with respect to the center plate 121. The second part 125b may extend to be curved in a downward direction from the first part 125a. The second part 125b may be parallel to the center plate 121. The third part 125c may extend to be curved in a forward direction from the second part 125b. The third part 125c may be parallel to the first part 125a. The connecting plate 125 may be referred to as an antenna holder 125 or an antenna plate 125.

The antenna module 130 may include a shield cover SD. The shield cover SD may be mounted on the rear surface of the substrate 131 (see FIGS. 9 and 10) of the antenna module 130. The shield cover SD may be positioned opposite to the first antenna portion 134 (see FIGS. 9 and 10) and the substrate 131 (see FIGS. 9 and 10). For example, the shield cover SD may include aluminum. The antenna module 130 may be coupled or fixed to the third part 125c of the connecting plate 125. For example, the shield cover SD of the antenna module 130 may be fixed to the third part 125c of the connecting plate 125. For another example, the shield cover SD of the antenna module 130 may be fixed to the third part 125c of the connecting plate 125 by an adhesive member AD. For example, the adhesive member AD may be a double-sided tape.

A component set 150 may include a substrate 151, sensors 152, 154, a microphone 153, a light source 155, and an IR light receiving unit 156, 157. For example, the substrate 151 may be a PCB. At least one of the sensors 152, 154, the microphone 153, the light source 155, and the IR light receiving unit 156, 157 may be mounted on the substrate 151. For example, the sensors 152, 154 may be an illuminance sensor 154 or a TOF sensor 152. For example, the light source 155 may be an LED. The illuminance sensor 154, the light source 155, and the IR light receiving unit 156 may be positioned adjacent to the antenna module 130. The front cover 110 may cover the component set 150 and/or the antenna module 130.

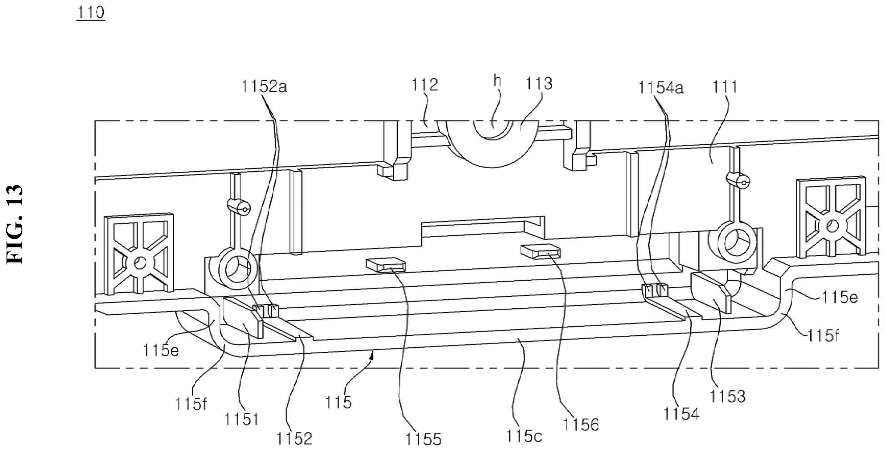

Referring to FIGS. 13 to 16, the front cover 110 may include a main part 111, an antenna dome 115, and an upper tab 112. The main part 111 may be in the shape of a plate which is elongated from side to side and curved at both ends. The upper tab 112 may extend from the edge of the upper long side of the main part 111. The upper tab 112 may be provided with a fastening boss 113 and/or a fastening hole h. For example, the front cover 110 may include a synthetic resin to be formed as one body. The front cover 110 may be coupled with the rear cover 119. For example, the rear cover 119 may include a synthetic resin. The front cover 110 and the rear cover 119 may be coupled to be referred to as a module housing 110, 119 or a housing 110, 119. The inner plate 120 and/or the rear cover 119 may face the rear surface of the frame 20 (see FIG. 8) or may be coupled with the frame 20 (see FIG. 8). The inner plate 120 and/or the rear cover 119 may be fixed to the boss 56a, 56b, the upper fixing portion 24a, 24b and/or the lower fixing portion 26a, 26b described with reference to FIG. 8.

The antenna dome 115 may be referred to as a radome 115. The antenna dome 115 may be positioned at the lower portion of the main part 111. The antenna dome 115 may include an upper part 115a, a front part 115b, a lower part 115c, and a side part 115e. The upper part 115a may be bent and extended from the edge of the lower long side of the main part 111. The upper part 115a may extend in a forward direction of the antenna dome 115. The front part 115b may extend downwardly of the antenna dome 115 from the front edge of the upper part 115a. The rear part 115c may extend from the lower edge of the front part 115b to the rear of the antenna dome 115. A center round part 115d may be formed between the lower part 115c and the front part 115b.

The antenna dome 115 may include a side part 115e. The side part 115e may form a wall against the lower part 115c at both the left and right ends of the lower part 115c. A side round part 115f may be formed between the side part 115e and the lower part 115c. The first side part 115e may be positioned at one short side of the lower part 115c, and the second side part 115e may be positioned at the other short side of the lower part 115c. The antenna dome 115 may have an overall tub shape.

A side rib 1151, 1153 may be positioned at the lower part 115c. The side rib 1151, 1153 may form a wall with respect to the lower part 115c. A first side rib 1151 may face the first side part 115e, and a second side rib 1153 may face the second side part 115e.

A lower rib 1152, 1154 may form a step raised from the lower part 115c. A first lower rib 1152 may be positioned opposite to the first side part 115e with respect to the first side rib 1151. A second lower rib 1154 may be positioned opposite to the second side part 115e with respect to the second side rib 1153. The height of the lower ribs 1152, 1154 may be smaller than the height of the side rib 1151, 1153. A spacer 1152a, 1154a may be formed on the inner side of the lower rib 1152, 1154 and/or the front part 115b (see FIG. 11). The spacer 1152a, 1154a may protrude from the lower rib 1152, 1154 and/or the front part 115b.

A front rib 1155, 1156 may be formed on the front part 115b. The front rib 1155, 1156 may protrude from the front part 115b toward the rear of the antenna dome 115. There may be a plurality of front ribs 1155, 1156. The first front rib 1155 may protrude and extend from the inner surface of the front part 115b, and the second front rib 1156 may be positioned adjacent to the first front rib 1155. A plurality of front ribs 1155, 1156 may be positioned between the first lower rib 1155 and the second lower rib 1156.

The connecting plate 125 may include a support tab 125d. The support tab 125d may extend from the second part 125b of the connecting plate 125. The support tab 125d may support a side surface of the antenna module 130. An adhesive member AD may be positioned between the support tab 125d and the side surface of the antenna module 130. The adhesive member AD may fix the side surface of the antenna module 130 to the support tab 125d. For example, the adhesive member AD may be an insulating double-sided tape. For another example, the adhesive member AD may be a rubber tape.

The antenna module 130 fixed to the third part 125c of the connecting plate 125 may be inserted into the antenna dome 115. The antenna module 130 and/or the third part 125c of the connecting plate 125 may be positioned between the lower part 115c of the antenna dome 115 and the front ribs 1155, 1156. The antenna module 130 may be spaced apart from the lower part 115c of the antenna dome 115, and the third part 125c of the connecting plate 125 may be supported on the front rib 1155, 1156 or come into contact with the front rib 1155, 1156. The lower side of distal end of the front rib 1155, 1156 may be tapered. The third part 125c of the connecting plate 125 may be supported on the lower surface of the front rib 1155, 1156 or may come into contact with the lower surface of the front rib 1155, 1156 while sliding on the tapered portion 1155a, 1156a of the front rib 1155, 1156. Accordingly, the gap formed between the antenna module 130 and the lower part 115c of the antenna dome 115 may be maintained at a constant level.

For example, the thickness D2 from the bottom surface of the antenna module 130 to the upper surface of the third part 125c of the connecting plate 125 may be 3 to 4 millimeters. For example, the thickness D1 of the lower part 115c of the antenna dome 115 may be 1.5 to 2 millimeters. For example, the distance D3 from the lower surface of the front rib 1155, 1156 to the upper surface of the upper part 115a of the antenna dome 115 may be 4 to 5 millimeters.

For another example, the thickness D2 from the bottom surface of the antenna module 130 to the upper surface of the third part 125c of the connecting plate 125 may be 3.6 millimeters. For another example, the thickness D1 of the lower part 115c of the antenna dome 115 may be 1.8 millimeters. For another example, the distance D3 from the lower surface of the front rib 1155, 1156 to the upper surface of the upper part 115a of the antenna dome 115 may be 4.5 millimeters.

For another example, the thickness D2 from the bottom surface of the antenna module 130 to the upper surface of the third part 125c of the connecting plate 125 may be about twice the thickness D1 of the lower part 115c of the antenna dome 115. For another example, the distance D3 from the lower surface of the front rib 1155, 1156 to the upper surface of the upper part 115a of the antenna dome 115 may be about 2.5 times the thickness D1 of the lower part 115c of the antenna dome 115.

Accordingly, the radiation performance of the antenna module 130 may be improved.

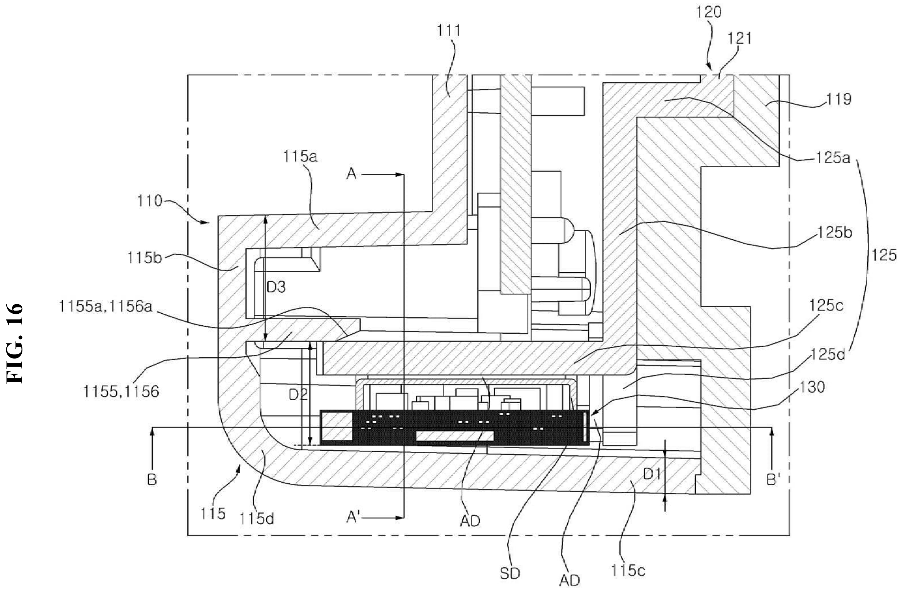

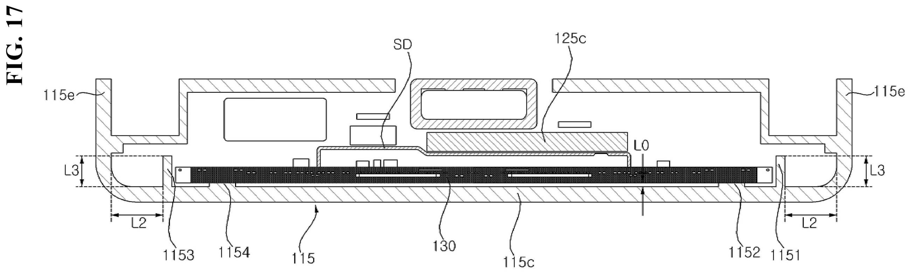

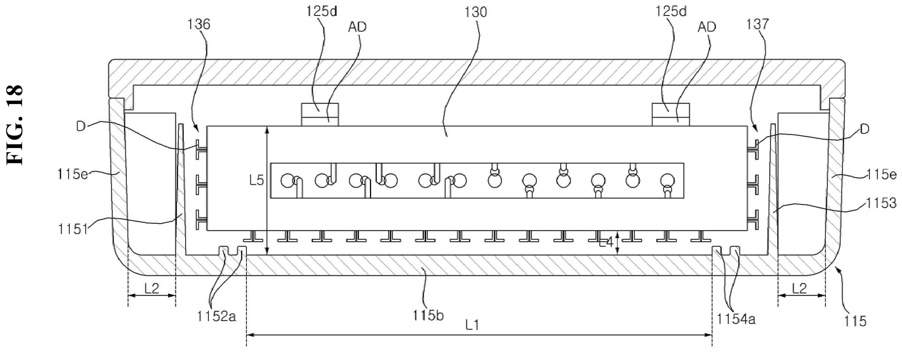

FIG. 17 is an example of the A-A' cross-sectional view of FIG. 16, and FIG. 18 is an example of the B-B' cross-sectional view.

Referring to FIGS. 17 and 18, a first space L0 may be formed between the bottom surface of the antenna module 130 and the lower part 115c by the lower rib 1152, 1154. The first space L0 may be referred to as a first air room L0 or a first room L0.

For example, a 21 distance L2 between the side part 115e and the first side rib 1151 may be 3 to 5 millimeters. A 22 distance L2 between the side part 115e and the second side rib 1153 may correspond to or be identical with the 21 distance L2. A 31 height L3 of the first side rib 1151 from the lower part 115c may be 2 to 3 millimeters. The 31 height L3 may be greater than the thickness of the antenna module 130. A 32 height L3 between the lower part 115c and the second side rib 1153 may correspond to or be identical with the 31 height L3.

As another example, the 21 distance L2 between the side part 115e and the first side rib 1151 may be 4 millimeters. The 22 distance L2 between the side part 115e and the second side rib 1153 may correspond to or be identical with the 21 distance L2. The 31 height L3 of the first side rib 1151 from the lower part 115c may be 2.5 millimeters. The 31 height L3 may be greater than the thickness of the antenna module 130. The 32 height L3 between the lower part 115c and the second side rib 1153 may correspond to or be identical with the 31 height L3.

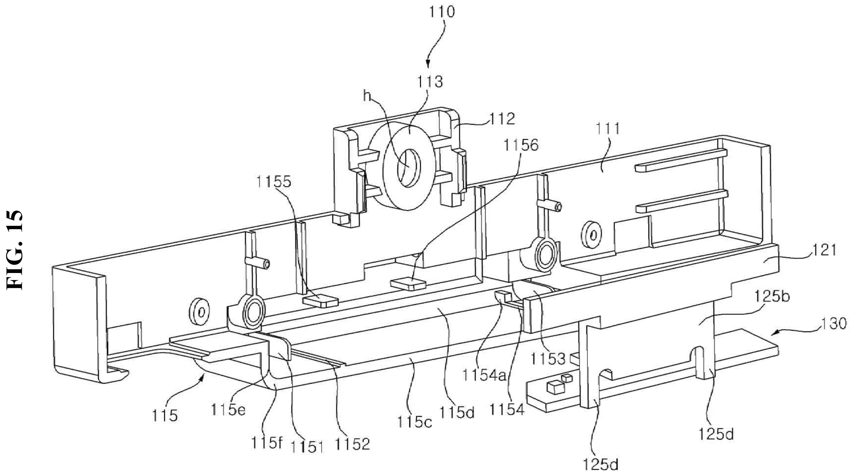

Referring to FIG. 18 together with FIG. 15, the spacer 1152a, 1154a may be formed on the lower rib 1152, 1154. The spacer 1152a, 1154a may protrude from the inner side of the lower rib 1152, 1154 and/or the front part 115b of the antenna dome 115.

For example, a 4 distance L4 between the side surface of the front of the antenna module 130 and the inner surface of the front part 115b of the antenna dome 115 may be 0.6 to 0.9 millimeters by the spacer 1152a, 1154a. For example, a 5 distance L5 between the side surface of the rear of the antenna module 130 and the inner surface of the front part 115b of the antenna dome 115 may be 10 to 11 millimeters. A second space L4 may be formed by the 4 distance L4. The second space L4 may be referred to as a second air room L4 or a second room L4.

For another example, the 4 distance L4 between the side surface of the front of the antenna module 130 and the inner surface of the front part 115b of the antenna dome 115 may be 0.8 millimeters by the spacer 1152a, 1154a. For another example, the 5 distance L5 between the side surface of the rear of the antenna module 130 and the inner surface of the front part 115b of the antenna dome 115 may be 10.5 millimeters. Accordingly, the radiation performance of the antenna module 130 may be improved.

Referring to FIGS. 1 to 18, a display device includes: a display panel having a plane for displaying an image; a frame which is positioned at a rear of the display panel, and to which the display panel is coupled; and a communication module which is positioned at one side of the frame, and protrudes outward from the one side of the frame, in which the communication module includes: a housing providing an internal space; and an antenna unit which is positioned in the internal space of the housing, has a bottom surface intersecting with the plane of the display panel, and has a side surface that forms an edge of the bottom surface and faces a front of the display panel, in which the antenna unit includes: a plurality of first antennas arranged on the bottom surface of the antenna unit; and a plurality of second antennas arranged on the side surface of the antenna unit, in which the housing includes: a lower rib forming a first air room by supporting the bottom surface of the antenna unit in the housing facing the bottom surface of the antenna unit; and a spacer which supports the side surface of the antenna unit and forms a second air room between the housing and the side surface of the antenna unit.

The housing includes: a rear cover positioned opposite to the side surface of the antenna unit with respect to the antenna unit; and a front cover which provides an antenna dome that covers the antenna unit, and is coupled to the rear cover, and the first air room and the second air room are formed between the antenna dome and the antenna unit.

The antenna dome includes: an upper part positioned opposite to the bottom surface of the antenna unit with respect to the antenna unit; a front part which is connected to the upper part, and faces the side surface of the antenna unit; and a lower part which is connected to the front part, and faces the bottom surface of the antenna unit, and the lower rib is formed by protruding from the lower part, and the spacer is formed by protruding from the lower rib or the front part.

The antenna unit includes: a first long side forming the side surface; a second long side positioned opposite to the side surface with respect to the antenna unit; a first short side connecting the first long side and the second long side; and a second short side positioned opposite to the first short side with respect to the antenna unit. The antenna dome includes: a first side part which faces the first short side of the antenna unit, forms a wall from the lower part, and is spaced apart from the first short side of the antenna unit; and a second side part which faces the second short side of the antenna unit, forms a wall from the lower part, and is spaced apart from the second short side of the antenna unit.

The antenna unit includes: a plurality of third antennas positioned on the first short side; and a plurality of fourth antennas positioned on the second short side.

The plurality of first antennas detect horizontal polarization and vertical polarization, and the plurality of second antennas, the plurality of third antennas, and the plurality of fourth antennas detect horizontal polarization.

The antenna dome includes: a first side rib positioned between the plurality of third antennas and the first side part; and a second side rib positioned between the plurality of fourth antennas and the second side part, in which a distance between the first side rib and the first side part corresponds to a distance between the second side rib and the second side part.

The antenna dome includes a front rib which is formed on the upper part or the front part, and supports an upper surface opposite to the bottom surface of the antenna unit with respect to the antenna unit.

The housing further includes an inner plate which is coupled to a rear of the frame, and is positioned between the frame and the rear cover, in which the inner plate includes: a center plate facing the frame; a side plate which extends from a side surface of the center plate, and is fixed to the rear of the frame; and a connecting plate which extends from the center plate, and is inserted into an interior of the housing, in which the connecting plate extends to the antenna dome, and is fixed to the antenna unit.

The antenna unit further includes: a substrate on which the plurality of first antennas are arranged; and a shield cover mounted on an opposite side of the plurality of first antennas with respect to the substrate, and the connecting plate is fixed to the shield cover.

The front rib of the antenna dome supports an upper side of the connecting plate.

A thickness from the bottom surface of the antenna unit to the upper side of the connecting plate is twice a thickness of the lower part of the antenna dome.

A distance from a lower surface of the front rib of the antenna dome to an upper surface of the upper part of the antenna dome is 2 to 3 times a thickness of the lower part of the antenna dome.

The communication module includes a PCB which is positioned between the front cover and the center plate, and has an electronic component mounted thereon, in which the PCB is positioned on an upper side of the antenna unit, and the electronic component includes at least one of an IR light receiving unit, a sensor, and a light source.

The plurality of first antennas detect horizontal polarization and vertical polarization, and the plurality of second antennas detect horizontal polarization.

The effects of the display device according to the present disclosure are described as follows.

According to at least one of the embodiments of the present disclosure, a display device having a wireless communication module can be provided.

According to at least one of the embodiments of the present disclosure, a display device capable of improving the reception rate of an antenna of a communication module can be provided.

According to at least one of the embodiments of the present disclosure, a display device capable of improving the radiation performance of an antenna of a communication module can be provided.

According to at least one of the embodiments of the present disclosure, a radome and an air room structure inside the radome for improving the radiation performance of an antenna that may be interfered with by electronic components surrounding an antenna of a communication module can be provided.

According to at least one of the embodiments of the present disclosure, a structure capable of effectively dissipating heat from a communication module can be provided.

According to at least one of the embodiments of the present disclosure, a display device capable of improving the assembly durability of an antenna can be provided.

Certain embodiments or other embodiments of the invention described above are not mutually exclusive or distinct from each other. Any or all elements of the embodiments of the invention described above can be combined or combined with each other in configuration or function.

For example, a configuration "A" described in one embodiment of the invention and the drawings and a configuration "B" described in another embodiment of the invention and the drawings may be combined with each other. Namely, although the combination between the configurations is not directly described, the combination is possible except in the case where it is described that the combination is impossible.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A display device comprising:
a display panel (10) having a plane for displaying an image;
a frame (20) which is positioned at a rear of the display panel (10), and to which the display panel (10) is coupled; and
a communication module (100) which is positioned at one side of the frame (20), and protrudes outward from the one side of the frame (20),
wherein the communication module (100) comprises:
a housing (110,119) providing an internal space; and
an antenna unit (130) which is positioned in the internal space of the housing (110,119), includes a bottom surface intersecting with the plane of the display panel (10), and includes a side surface that forms an edge of the bottom surface and faces a front of the display panel (10),
wherein the antenna unit (130) comprises:
a plurality of first antennas (134) arranged on the bottom surface of the antenna unit (130); and
a plurality of second antennas (135) arranged on the side surface of the antenna unit (130),
wherein the housing (110,119) comprises:
a lower rib (1152,1154) forming a first air room (L0) by supporting the bottom surface of the antenna unit (130) in the housing (110,119) facing the bottom surface of the antenna unit (130); and
a spacer (1152a,1154a) which supports the side surface of the antenna unit (130) and forms a second air room (L4) between the housing (110,119) and the side surface of the antenna unit (130).

2. The display device of claim 1, wherein the housing (110,119) comprises:
a rear cover (119) positioned opposite to the side surface of the antenna unit (130) with respect to the antenna unit (130); and
a front cover (110) which provides an antenna dome (115) that covers the antenna unit (130), and is coupled to the rear cover (119),
wherein the first air room (L0) and the second air room (L4) are formed between the antenna dome (115) and the antenna unit (130).

3. The display device of claim 2, wherein the antenna dome (115) comprises:
an upper part (115a) positioned opposite to the bottom surface of the antenna unit (130) with respect to the antenna unit (130);
a front part (115b) which is connected to the upper part (115a), and faces the side surface of the antenna unit (130); and
a lower part (115c) which is connected to the front part (115b), and faces the bottom surface of the antenna unit (130),
wherein the lower rib (1152,1154) is formed by protruding from the lower part (115c), and
wherein the spacer (1152a,1154a) is formed by protruding from the lower rib (1152,1154) or the front part (115b).

4. The display device of claim 3, wherein the antenna unit (130) comprises:
a first long side forming the side surface;
a second long side positioned opposite to the side surface with respect to the antenna unit (130);
a first short side connecting the first long side and the second long side; and
a second short side positioned opposite to the first short side with respect to the antenna unit (130),
wherein the antenna dome (115) comprises:
a first side part (115e) which faces the first short side of the antenna unit (130), forms a wall from the lower part (115c), and is spaced apart from the first short side of the antenna unit (130); and
a second side part (115e) which faces the second short side of the antenna unit (130), forms a wall from the lower part (115c), and is spaced apart from the second short side of the antenna unit (130).

5. The display device of claim 4, wherein the antenna unit (130) comprises:
a plurality of third antennas (136) positioned on the first short side; and
a plurality of fourth antennas (137) positioned on the second short side.

6. The display device of claim 5, wherein the plurality of first antennas (134) detects horizontal polarization and vertical polarization, and
the plurality of second antennas (135), the plurality of third antennas (136), and the plurality of fourth antennas (137) detect horizontal polarization.

7. The display device of claim 5, wherein the antenna dome (115) comprises:
a first side rib (1151) positioned between the plurality of third antennas (136) and the first side part (115e); and
a second side rib (1153) positioned between the plurality of fourth antennas (137) and the second side part (115e),
wherein a distance (L2) between the first side rib (1151) and the first side part (115e) corresponds to a distance (L2) between the second side rib (1153) and the second side part (115e).

8. The display device of claim 3, wherein the antenna dome (115) comprises a front rib (1155,1156) which is formed on the upper part (115a) or the front part (115b), and supports an upper surface opposite to the bottom surface of the antenna unit (130) with respect to the antenna unit (130).

9. The display device of claim 8, wherein the housing further comprises an inner plate (120) which is coupled to a rear of the frame (20), and is positioned between the frame (20) and the rear cover (119),
wherein the inner plate (120) comprises:
a center plate (121) facing the frame (20);
a side plate (122,123) which extends from a side surface of the center plate (121), and is fixed to the rear of the frame (20); and
a connecting plate (125) which extends from the center plate (121), and is inserted into an inside of the housing,
wherein the connecting plate (125) extends to the antenna dome (115), and is fixed to the antenna unit (130).

10. The display device of claim 9, wherein the antenna unit (130) further comprises:
a substrate (131) on which the plurality of first antennas (134) is arranged; and
a shield cover (SD) mounted on an opposite side of the plurality of first antennas (134) with respect to the substrate (131),
wherein the connecting plate (125) is fixed to the shield cover (SD).

11. The display device of claim 10, wherein the front rib (1155,1156) of the antenna dome (115) supports an upper side of the connecting plate (125).

12. The display device of claim 11, wherein a thickness (D2) from the bottom surface of the antenna unit (130) to the upper side of the connecting plate (125) is substantially twice a thickness of the lower part (115c) of the antenna dome (115).

13. The display device of claim 11, wherein a distance (D3) from a lower surface of the front rib (1155,1156) of the antenna dome (115) to an upper surface of the upper part (115a) of the antenna dome (115) is 2 to 3 times a thickness (D1) of the lower part (115c) of the antenna dome (115).

14. The display device of claim 9, wherein the communication module (100) comprises a PCB (151) which is positioned between the front cover (110) and the center plate (121), and includes an electronic component mounted thereon,
wherein the PCB (151) is positioned on an upper side of the antenna unit (130), and
the electronic component comprises at least one of an IR light receiving unit (156,157), a sensor (152,154), and a light source (155).

15. The display device of claim 1, wherein the plurality of first antennas (134) detects horizontal polarization and vertical polarization, and
the plurality of second antennas (135) detects horizontal polarization.
